# EUROPEAN PATENT SPECIFICATION

(11) **EP 4 096 353 B1**
(45) Date of publication and mention of the grant of the patent: **19.08.2026**
(21) Application number: 22175972.3
(22) Date of filing: 30.05.2022
(51) Int. Cl.: H05B 6/12, F24C 15/10

(54) **ELECTRIC RANGE**
ELEKTROHERD
CUISINIÈRE ÉLECTRIQUE

(30) Priority: 28.05.2021 KR 20210069178
(43) Date of publication of application: 30.11.2022
(73) Proprietor: LG Electronics Inc., SEOUL 07336 (KR)
(72) Inventor: KIM, Seunghak, 08592 Seoul (KR); CHO, Junghyeon, 08592 Seoul (KR)
(74) Representative: Vossius & Partner Patentanwälte Rechtsanwälte mbB

(56) References cited:
- EP-A1- 3 628 931
- KR-A- 20090 121 787
- US-A1- 2008 142 512

## Description

### BACKGROUND

### 1. Field

An electric range is disclosed herein.

### 2. Background

This section provides background information related to the present disclosure, which is not necessarily prior art.

Various types of cooking appliances are used to heat food or other items (hereinafter, collectively "food") at home or in a restaurant. Examples of such a cooking appliance include a gas range and an electric range.

An electric range is largely classified into a resistance heating type and an induction heating type. A resistance heating electric range heats an item to be heated, for example, cookware, such as a pot or a frying pan, through radiation or conduction of heat generated by applying electric current to a metal resistance wire or a non-metallic heating element, such as silicon carbide. An induction heating electric range heats a metallic item to be heated by inducing eddy current in the item using a magnetic field generated around a coil through application of high-frequency power to the coil.

The basic principle of induction heating is as follows. When high-frequency current is applied to a working coil or a heating coil, a magnetic field is generated around the coil. As the item is heated by electromagnetic induction caused by the generated magnetic field, heat is generated from the item, thereby heating food inside of the item.

An electric range includes an inner space in which various electronic components are disposed. The inner space can become hot due to various factors. For example, the inner space can become hot due to heat from an item to be heated, for example, a container in which food is placed, or heat generated from electronic components, for example, a power device or a switching device that generates high-frequency power, disposed in the inner space. If the inner space becomes excessively hot, the electric range can fail to operate normally. Accordingly, the electric range generally includes an air blower fan to cool the inner space.

However, if the amount of air drawn into the air blower fan is not sufficient, this causes reduction in cooling efficiency. Therefore, there is a need for structure that allows a sufficient amount of air to be drawn into the air blower fan.

EP 3 628 931 (A1) relates to an induction hob comprising an inlet opening portion for drawing in outside air on the side of the intake space, which lengthens the airflow path.

KR 2009 0121787 (A) relates to an electric hob for cooking food using electricity.

US 2008/142512 (A1) relates to a cooking appliance efficiently cooling electric heating elements thereof.

### BRIEF DESCRIPTION OF THE DRAWINGS

Embodiments will be described in detail with reference to the following drawings in which like reference numerals refer to like elements, and wherein:
FIG. 1 a perspective view of an electric range according to an embodiment;
FIG. 2 is a perspective view of a main body of the electric range of FIG. 1 according to an embodiment;
FIG. 3 is an exploded perspective view of the electric range of FIG. 1;
FIG. 4 is a perspective view of the electric range of FIG. 1, with an upper plate, heating modules, and an upper bracket removed therefrom;
FIG. 5 is a perspective view of a second support of the electric range according to an embodiment, with an air blower fan coupled thereto;
FIG. 6 is a top exploded perspective view of the second support and the air blower fan of FIG. 5;
FIG. 7 is a bottom exploded perspective view of the second support and the air blower fan of FIG. 5;
FIG. 8 is a plan view of a second support of the electric range according to an embodiment;
FIG. 9 is a cross-sectional view of the second support of the electric range of FIG. 8, taken along line IX-IX;
FIG. 10 is a plan view of a case of the electric range according to an embodiment;
FIG. 11 is a cross-sectional view of the case of the electric range of FIG. 10, taken along line XI-XI';
FIG. 12 is an enlarged cross-sectional view of an intake portion of the electric range of FIG. 10 according to an embodiment;
FIG. 13 is a plan view of the electric range of FIG. 4, with an upper plate, heating modules, and an upper bracket removed therefrom; and
FIG. 14 is a cross-sectional view of the electric range of FIG. 13, showing a region in which an air blower fan is disposed, taken along line XIV-XIV'.

### DETAILED DESCRIPTION

Reference will now be made to various embodiments, examples of which are illustrated in the accompanying drawings such that embodiments may be easily implemented by those skilled in the art. Description of known functions and constructions which may unnecessarily obscure the subject matter will be omitted. Like components will be denoted by like reference numerals throughout the specification.

It will be understood that, although the terms "first" and "second", for example, may be used herein to describe various elements, these elements should not be limited by these terms. These terms are only used to distinguish one element from another element. Thus, unless stated otherwise, a first element discussed below could be termed a second element, or vice versa, without departing from the scope.

It will be understood that, when a component is referred to as being disposed "at an upper (lower) portion of" or "on (or "under") another component, it can be directly formed to adjoin an upper surface ("a lower surface") of the other component, or intervening component(s) may be interposed therebetween.

In addition, when a component is referred to as being "connected to", "coupled to" or "joined to" another component, these components may be connected, coupled, or joined to each other directly or through another component, or intervening component(s) may be "interposed" therebetween.

Throughout, unless stated otherwise, each element may be singular or plural in number.

As used herein, the singular forms, "a," "an," and "the" are intended to include the plural forms as well, unless the context clearly indicates otherwise. Moreover, the terms "comprises," "comprising," "includes," and/or "including," when used in this specification, should not be construed to mean that a process, method, article, or apparatus comprising a list of elements or steps necessarily comprises all the elements or all the steps. Thus, such a process, method, article, or apparatus may be free from some of the elements or the steps, or may further include one or more other elements or steps.

Throughout, the expression "A and/or B" means A, B, or A and B, unless stated otherwise, and the expression "C to D" means "greater than or equal to C and less than or equal to D", unless stated otherwise.

Hereinafter, an electric range according to an embodiment will be described.

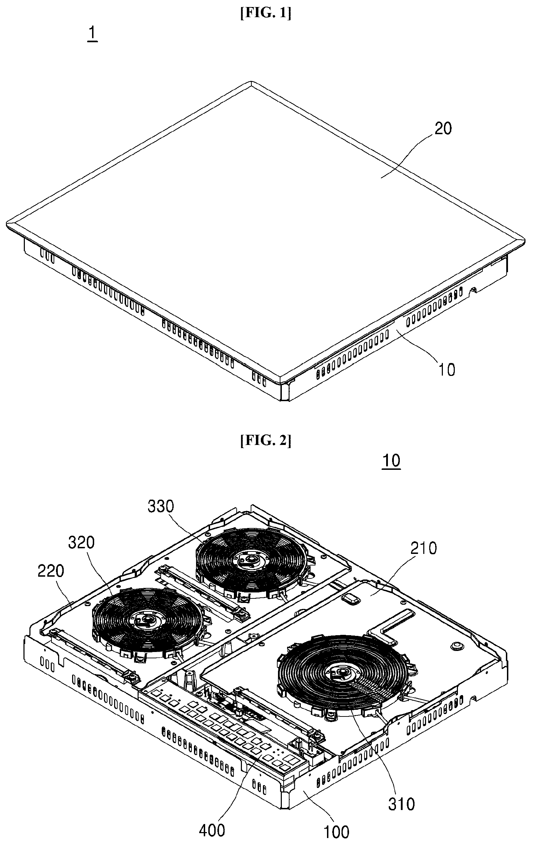

FIG. 1 is a perspective view of an electric range according to an embodiment. FIG. 2 is a perspective view of a main body of the electric range according to an embodiment.

Referring to FIG. 1, the electric range 1 according to this embodiment may include a main body 10 and an upper plate 20. Referring to FIG. 2, the main body 10 may include a case 100, a first upper bracket 210, a second upper bracket 220, a first heater 310, a second heater 320, and a third heater 330, and an operation unit 400.

Hereinafter, a side of the electric range 1 on which the operation unit 400 is disposed is defined as "front" and a side opposite the front is defined as "rear". In addition, a right or first lateral side of the electric range 1 as viewed from the front is defined as "right" and a left or second lateral side of the electric range 1 as viewed from the front is defined as "left".

The main body 10 may include at least one heater and a drive unit that operates the heater. The heater may heat an item to be heated. The drive unit may include the operation unit 400 and multiple components disposed on a printed circuit board.

The case 100 may receive the printed circuit board having various components thereon, and a support on which the printed circuit board is mounted, for example. The case 100 may be provided in the form of a generally cuboidal box which is open at a top thereof, for example. The case 100 may define a component housing space therein.

The case 100 may serve to protect components of the electric range. The case 100 may be formed of aluminum, for example; however, embodiments are not limited thereto. In some embodiments, the case 100 may be insulated to suppress leakage of heat generated by the heaters 310, 320, and/or 330 to outside of the electric range 1.

The first upper bracket 210 may support first heater 310, and the second upper bracket 220 may support second heater 320 and third heater 330. The first upper bracket 210 and the second upper bracket 220 may be coupled to the case 100.

The first heater 310, the second heater 320, and the third heater 330 may heat an item to be heated. The heaters 310, 320, 330 may heat the item to be heated through induction heating. Alternatively, the heaters 310, 320, 330 may heat the item to be heated by resistance heating. Alternatively, some of the heaters 310, 320, 330 may heat the item to be heated by induction heating and the others may heat the item to be heated by resistance heating. When induction heating is employed to heat the item to be heated, high-frequency power may be applied to a working coil of each of the heaters 310, 320, 330. When high-frequency power is applied to the working coil, a magnetic field is generated around the working coil, inducing eddy current in the item to be heated. As a result, the item to be heated, which is formed of a metal, may be heated by the eddy current.

The first heater 310, the second heater 320, and the third heater 330 may be disposed under the upper plate 20. The first heater 310 may be mounted on the first upper bracket 210, and the second heater 320 and the third heater 330 may be mounted on the second upper bracket 220.

In the following description, it is assumed that the electric range includes three heaters that heat an item to be heated by induction heating and two upper brackets. However, it should be understood that a type and number of heaters and a number of upper brackets are not limited thereto.

The operation unit 400 allows a user to input a command to operate the electric range 1. The operation unit 400 may be disposed in front of the first upper bracket 210. In addition, the operation unit 400 may be disposed at the front of the electric range between the upper plate 20 and the case 100 for user convenience. However, it should be understood that embodiments are not limited thereto and a position of the operation unit 400 may be changed differently from that shown in FIG. 1, as needed.

The operation unit 400 may include a plurality of key switches. A user may control operation of the electric range by inputting a command to the operation unit 400 using the plurality of key switches.

An upper surface of the operation unit 400 may be placed under a cover plate 21. The operation unit 400 may correspond in location to an input interface on the cover plate 21. The operation unit 400 and the input interface may be connected to each other by a touch input method.

The upper plate 20 may be coupled to an upper portion of the main body 10, and may provide a space in or on which an item to be heated is seated.

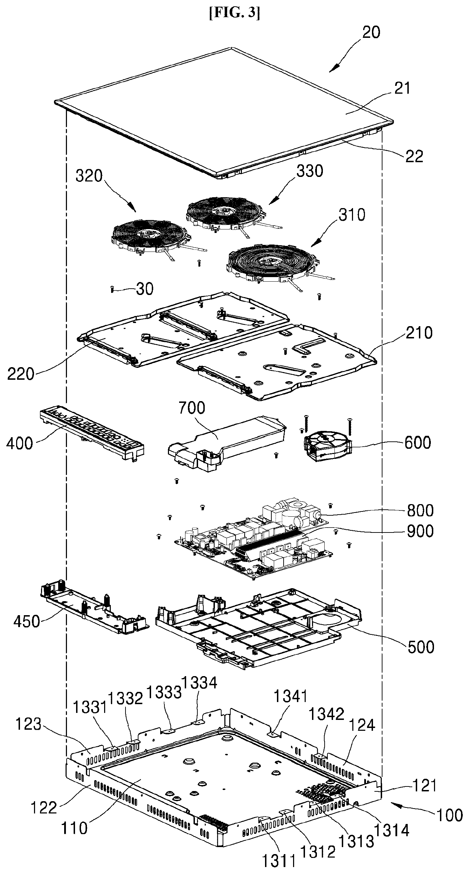

FIG. 3 is an exploded perspective view of an electric range according to an embodiment. Referring to FIG. 3, the electric range 1 according to this embodiment may include main body 10 and upper plate 20. The main body 10 of the electric range 1 according to this embodiment may include case 100, first upper bracket 210, second upper bracket 220, first heater 310, second heater 320, third heater 330, operation unit 400, a first support 450, a second support 500, an air blower fan 600, an air guide 700, a printed circuit board 800, and a heat sink 900. The upper plate 20 of the electric range 1 according to this embodiment may include cover plate 21 and a cover bracket 22.

The cover plate 21 may close an upper portion of a housing space defined by the case 100. The cover plate 21 may serve to protect various components inside of the housing space defined by the case 100.

In addition, the cover plate 21 may have an upper surface on which an item to be heated is disposed. When the electric range 1 employs induction heating, a magnetic field generated by the heaters 310, 320, and/or 330 may pass through the cover plate 21 before reaching the item to be heated. The cover plate 21 may be formed of a ceramic material, for example; however, embodiments are not limited thereto.

The cover plate 21 may be provided on the upper surface thereof with an input interface configured to receive a user input. The input interface may be disposed in a specific region on the upper surface of the cover plate 21, and may display a specific image. The input interface may receive a touch input from a user, and the electric range may be operated based on the received touch input. The touch input may be input to the operation unit 400.

In addition, a display may be disposed in a specific region of the upper surface of the cover plate 21 to display an operating state of the electric range 1. For example, an optical display region may be formed on the upper surface of the cover plate 21 and a light source unit may be disposed under the cover plate 21. Accordingly, light emitted from the light source unit may be delivered to a user through the optical display region. The optical display region may correspond in location of the light source unit. When a plurality of light source units is provided, an equal number of optical display regions may be formed on the upper surface of the cover plate 21.

The cover bracket 22 may support the cover plate 20. The cover bracket 22 may be disposed outside of the case 100, and may be coupled to the case 100. For example, the cover bracket 22 and the case 100 may be coupled to each other using a fastener, such as a bolt.

The cover bracket 22 may have a generally rectangular shape, for example. Sides of the cover bracket 22 may correspond in location to sides of the cover plate 21, respectively.

A shape and function of case 100 may be the same as described above with reference to FIG. 1 and FIG. 2. The case 100 may be formed of a generally plate-shaped material fabricated in the form of a box, for example.

The case 100 may include a first casing 110, second casings 121, 122, 123, 124, and third casings 1311, 1312, 1313, 1314, 1331, 1332, 1333, 1334, 1341, 1342. The first casing 110 may form a bottom surface of the case 100. The first casing 110 may have a generally rectangular shape, for example. The first support 450 and the second support 500 may be mounted on an upper surface of the first casing 110.

The first casing 110 may be provided with at least one air vent to facilitate cooling of the printed circuit board 800 disposed therein and electronic components mounted on the printed circuit board 800. More specifically, the first casing 100 may be formed with an intake portion through which external air is introduced thereinto and a discharge portion through which internal air is discharged therefrom.

The second casings 121, 122, 123, 124 may be bent from the first casing 110 and may define an external appearance of the case 100. According to one embodiment, second-1 casing 121 may form a right or first lateral surface of the case 100, a second-2 casing 122 may form a front surface of the case 100, and second-3 casing 123 may form a left or second lateral surface of the case 100, and second-4 casing 124 may form a rear surface of the case 100.

The second casings 121, 122, 123, 124 may be vertically bent from an edge of the first casing 110 to form an exterior of the case 100. The second casings 121, 122, 123, 124 may be disposed on four sides of the first casing 110 having a generally rectangular shape, respectively. The second casings 121, 122, 123, 124 may reinforce an overall rigidity of the case 10.

That is, the second casings 121, 122, 123, 124 bent from the first casing 110 may prevent the plate-shaped first casing 110 from being warped or damaged by a weight of internal components or by an external force. In addition, the first casing 110 may have a bent portion to reinforce the overall rigidity of the case 10, as described hereinafter.

Each of the second casings 121, 122, 123, 124 may have multiple slit-shaped ventilation holes. The ventilation holes allow the inside and outside of the case 100 to communicate with each other to allow a flow of air into/out of the case 100, thereby contributing to cooling of components received in the case 100.

The third casings 1311, 1312, 1313, 1314, 1331, 1332, 1333, 1334, 1341, 1342 may support the first upper bracket 210 and the second upper bracket 220. Each of the third casings 1311, 1312, 1313, 1314, 1331, 1332, 1333, 1334, 1341, 1342 may be bent from an upper end of a corresponding one of the second casings 121, 123, 124. More specifically, third-1 casings 1311, 1312, 1313, 1314 may be bent to the left or lateral side from an upper end of the second-1 casing 121, third-3 casings 1331, 1332, 1333, 1334 may be bent to the right or lateral side from an upper end of the second-3 casing 123, and third-4 casings 1341, 1342 may be bent forward from an upper end of the second-4 casing 124.

Each of the third-1 casings 1311, 1312, 1313, 1314 and the third-42 casing 1342 may have a hole for coupling with the first upper bracket 210. With a bottom surface of the first upper bracket 210 seated on upper surfaces of the third-1 casings 1311, 1312, 1313, 1314 and the third-42 casing 1342, the first upper bracket 210 may be coupled to each of the third-1 casings 1311, 1312, 1313, 1314 and the third-42 casing 1342 using a coupling member, such as a bolt, for example. Each of the third casings 1331, 1332, 1333, 1334 and the third-41 casing 1341 may have a hole for coupling with the second upper bracket 210. With a bottom surface of the second upper bracket 220 seated on upper surfaces of the third casings 1331, 1332, 1333, 1334 and the third-41 casing 1341, the second upper bracket 220 may be coupled to each of the third casings 1331, 1332, 1333, 1334 and the third-41 casing 1341 using a coupling member, such as a bolt, for example.

The first support 450 may support the operation unit 400. The first support 450 may be coupled to the first casing 110 of the case 100 using a bolt, for example. The operation unit 400 may be mounted on the first support 450. The operation unit 400 may be coupled to the first support 450 by interference fit, for example.

The second support 500 may support the printed circuit board 800 and the air blower fan 600. The second support 500 may be coupled to the first casing 110 of the case 100 using a bolt, for example.

Various electronic components may be mounted on the printed circuit board 800 to operate the heat sink 900, and the heaters 310, 320, 330, for example. The printed circuit board 800 may be mounted on the second support 500 using a bolt, for example.

The electronic components mounted on the printed circuit board 800 may be powered by an external power source and may output high-frequency power to the heaters 310, 320, 330. In addition, the electronic components mounted on the printed circuit board 800 may be electrically connected to the operation unit 400, and may operate the heaters 310, 320, 330 in response to a user command input via the operation unit 400. According to some embodiments, the electronic components mounted on the printed circuit board 800 may communicate with an external device through a wire or electronically. That is, the electronic components mounted on the printed circuit board 800 may function as a controller that controls an overall operation of the electric range 1.

A device that generates a lot of heat, such as a switching device that generates high-frequency power, may be attached to the heat sink 900. The heat sink 900 may cool the device attached thereto.

The air blower fan 600 may take in air through an inlet thereof and may discharge the air through an outlet thereof. The air blower fan 600 may take in external air through the intake portion of the first casing 110. In addition, air discharged through the outlet of the air blower fan 600 may be discharged to the housing space defined by the case 100. At least a portion of the air discharged through the outlet of the air blower fan 600 may be guided to the heat sink 900 by the air guide 700 to cool the heat sink 900. The air guided by the air guide 700 may be discharged to the outside of the electric range 1 through the discharge portion of the first casing 110 after cooling the heat sink 900.

The air blower fan 600 may be mounted on the second support 500. The air blower fan 600 may be mounted on the second support 500 using a coupling member, such as a bolt, for example.

According to some embodiments, the air blower fan 600 may be coupled to the case 100 using a coupling member, such as a bolt, for example. More specifically, the bolt may be coupled to the first casing 110 of the case 100 through the air blower fan 600 and the second support 500. In this way, it is possible to maintain coupling between the air blower fan 600, the second support 500, and the case 100 even when the first casing 110, for example, undergoes deformation and to prevent air inside of the electric range 1 from being introduced into the air blower fan 600.

The air guide 700 may guide air discharged from the air blower fan 600 to move to the discharge portion of the first casing 110 of the case 100 via the heat sink 900. The air guide 700 may be mounted on the printed circuit board 800. More specifically, the air guide 700 may be mounted on the printed circuit board 800 to completely cover the heat sink 900 mounted on the printed circuit board 800.

Basic functions of the first upper bracket 210 and the second upper bracket 220 may be the same as described above with reference to FIG. 1 and FIG. 2. The first upper bracket 210 and the second upper bracket 220 may be secured to the case 100. The first upper bracket 210 and the second upper bracket 220 may be formed of aluminum; however, embodiments are not limited thereto.

The first upper bracket 210 may be disposed under the first heater 310, and the second upper bracket 220 may be disposed under the second heater 320 and the third heater 330. The first upper bracket 210 and the second upper bracket 220 may be disposed between the upper plate 20 and the space housing the printed circuit board 800 and the electronic components. Due to this structure, the first upper bracket 210 and the second upper bracket 220 may serve as a shield to prevent electromagnetic fields and/or electromagnetic waves generated from the heaters 310, 320, 330 from reaching the printed circuit board 800 and the electronic components. That is, the first upper bracket 210 and the second upper bracket 220 may serve to improve electromagnetic compatibility (EMC) of the printed circuit board 800 and to provide electromagnetic interference (EMI) shielding for the printed circuit board 800.

Each of the first upper bracket 210 and the second upper bracket 220 may include a first upper plate and a second upper plate. The first upper plate may form a bottom surface of each of the first upper bracket 210 and the second upper bracket 220. In addition, the heaters 310, 320, 330 may be mounted on the first upper plate.

The second upper plate may be bent from the first upper plate in a vertical direction of the electric range 1. The second upper plate may be vertically bent from an edge of the first upper plate.

The second upper plate may be disposed on each side of the first upper plate having a generally rectangular shape. The second upper plate may reinforce an overall rigidity of the first upper bracket 210 and the second upper bracket 220. That is, the second upper plate bent from the first upper plate may prevent the first upper plate from being warped or damaged by the weight of internal components including the heaters 310, 320, 330 or by an external force.

Due to the arrangement described above with reference to FIG. 3, all of the components of the electric range 1 may be assembled on the case 100. Accordingly, a manufacturing process of the electric range may be simplified, thereby improving production efficiency.

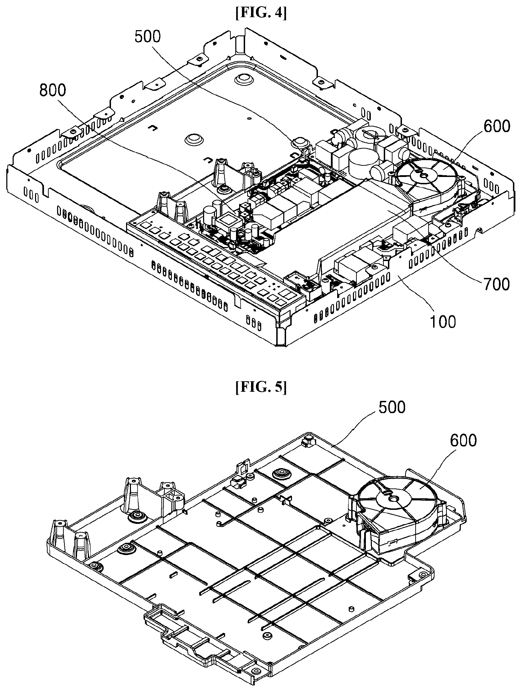

FIG. 4 is a perspective view of the electric range according to an embodiment, with the upper plate, the heating modules, and the upper bracket removed therefrom. As described above, the second support 500 may be mounted on the case 100. More specifically, the second support 500 may be mounted on the upper surface of the first casing 110 (see FIG. 3) of the case 100 using a coupling member, such as a bolt, for example. In addition, the second support 500 may include an intake hole and a discharge hole. The intake hole of the second support 500 may adjoin the intake portion of the first casing 110 (see FIG. 3) of the case 100. The discharge hole of the second support 500 may adjoin the discharge portion of the first casing 110 (see FIG. 3) of the case 100.

The air blower fan 600 and the printed circuit board 800 may be mounted on the second support 500. Various electronic components including the heat sink 900 (see FIG. 3) may be mounted on the upper surface of the printed circuit board 800. The inlet of the air blower fan 600 may adjoin the intake hole of the second support 500. The outlet of the air blower fan 600 may adjoin one end of the air guide 700.

The air guide 700 may be mounted on the upper surface of the printed circuit board 800 to cover the heat sink 900. The air guide 700 may be open at a rear and bottom thereof. The air guide 700 may have a generally cuboidal shape. One or a first end (a rear surface) of the air guide 700 may adjoin the outlet of the air blower fan 600 and the other or a second end (a front portion of a lower surface) of the air guide 700 may adjoin the discharge hole of the second support 500.

When the air blower fan 600 is operated, air outside of the electric range 1 may be drawn into the inlet of the air blower fan 600 via the intake portion of the case 100 and the intake hole of the second support 500. In addition, air discharged through the outlet of the air blower fan 600 may be moved along the air guide 700 and then may be discharged to the outside of the electric range 1 via the discharge hole of the second support 500 and the discharge portion of the case.

Hereinafter, features of the second support 500 and the first casing 110 of the case 100 will be described.

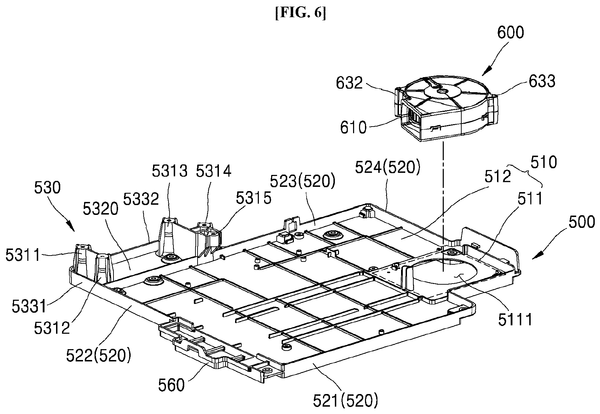

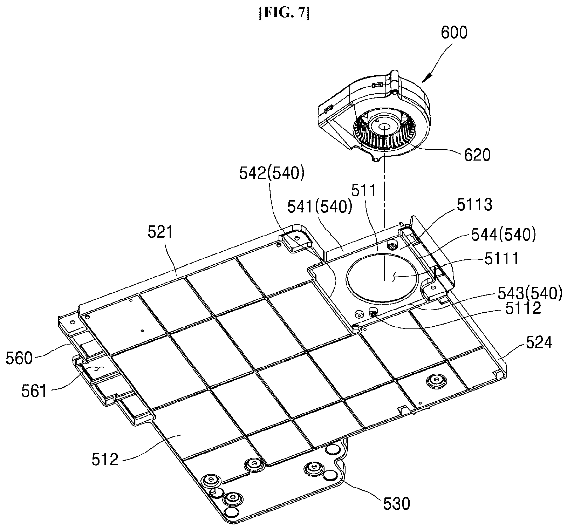

FIG. 5 is a perspective view of a second support of the electric range according an embodiment, with an air blower fan coupled thereto. FIG. 6 is a top exploded perspective view of the second support and the air blower fan of FIG. 5. FIG. 7 is a bottom exploded perspective view of the second support and the air blower fan of FIG. 5.

The air blower fan 600 may be disposed on an upper surface of the second support 500. The air blower fan 600 may include an outlet 610 (see FIG. 6), an inlet 620 (see FIG. 7), and securing portions 632, 633 (see FIG. 6).

The second support 500 may include a bottom plate 510 and a side plate 520. The bottom plate 510 may form a bottom surface of the second support 500. The printed circuit board 800 and the air blower fan 600 may be mounted on an upper surface of the bottom plate 510. The bottom plate 510 may include a first region 511 in which the air blower fan 600 may be mounted and a second region 512 in which the printed circuit board 800 may be mounted. The first region 511 may have an intake hole 5111 through which air is drawn in.

The side plate 520 may be bent from the bottom plate 510 in a vertical direction of the electric range 1. The side plate 520 may be vertically bent from an edge of the bottom plate 510.

The side plate 520 may be disposed on each side of the bottom plate 510 having a generally rectangular shape, for example. That is, the side plate 520 may include first side plate 521 disposed on a right or first lateral surface of the bottom plate 510, second side plate 522 disposed on a front surface of the bottom plate 510, a third side plate 523 disposed on a left or second lateral surface of the bottom plate 510, and a fourth side plate 524 disposed on a rear surface of the bottom plate 510. The first side plate 521 may adjoin the second-1 casing 121 (see FIG. 3) of the case 100, the second side plate 522 may adjoin the second-2 casing 122 (see FIG. 3) of the case 100, and the fourth side plate 524 may adjoin the second-4 casing 124 (see FIG. 3) of the case 100. Hereinafter, the term "adjoin" means that a corresponding component is in close contact with another component, or is placed very close to the other component.

The side plate 520 may reinforce an overall rigidity of the second support 500. That is, the side plate 520 bent from the bottom plate 510 may prevent the bottom plate 510 from being warped or damaged by the weight of internal components, such as the printed circuit board 800 and the air blower fan 600, or by an external force.

Referring to FIG. 6, the second support 500 may further include a boss portion 530. The boss portion 530 may include a plurality of bosses 5311, 5312, 5313, 5314, 5315. Each of the plurality of bosses 5311, 5312, 5313, 5314, 5315 may support either the first upper bracket 210 or the second upper bracket 220. According to one embodiment, boss 5315 may support the first upper bracket 210 and bosses 5311, 5313 may support the second upper bracket 220. The boss 5315 may be coupled to the first upper bracket 210 using a coupling member, such as a bolt, for example, and the bosses 5311, 5313 may be coupled to the second upper bracket 220 using a coupling member, such as a bolt, for example.

The boss portion 530 may include a bottom plate 5320 and side plates 5331, 5332. The bottom plate 5320 may form a bottom surface of the boss portion 530. The side plates 5331, 5332 may be vertically bent from an edge of the bottom plate 5320. The side plates 5331, 5332 may improve an overall rigidity of the boss portion 530.

In addition, the second support 500 may further include a discharge portion 560 having a discharge hole 561. The discharge portion 560 may adjoin a lower front end of the air guide 700 (see FIG. 3 and FIG. 4). At least a portion of air discharged through the outlet 610 (see FIG. 6) of the air blower fan 600 may be guided to the heat sink 900 (see FIG. 3) by the air guide 700 to cool the heat sink 900, and then may be discharged to the outside of the electric range 1 through the discharge hole 561 of the discharge portion 560.

Referring to FIG. 6 and FIG. 7, the air blower fan 600 may be mounted in the first region 511 of the bottom plate 510 of the second support 500. The first region 511 may include intake hole 5111 that provides a passage through which air is drawn into the air blower fan 600. The intake hole 5111 may have a size larger than or equal to a size of the air blower fan 600. The first region 511 may include fan securing holes 5112, 5113 for mounting the air blower fan 600 thereto. The air blower fan 600 may be secured to the second support 500 using coupling members, such as bolts, for example, each passing through a corresponding one of the securing portions 632, 633 of the air blower fan 600 and a corresponding one of the fan securing holes 5112, 5113.

With the second support 500 coupled to the case 100, a distance between an upper surface of the first casing 110 of the case 100 and a lower surface of the first region 511 may be greater than a distance between the upper surface of the first casing 110 and a lower surface of the second region 512. That is, the second support 500 may serve to separate the inlet 620 of the air blower fan 600 from the upper surface of the first casing 110 by a predetermined distance. In this way, it is possible to effectively increase an intake area of the air blower fan 60.

Referring to FIG. 7, the second support 500 may include a 540 that protrudes downward from the lower surface of the first region 511 and surrounds the intake hole 5111. The rib 540 may prevent air in a region other than a space under the first region 511 from being drawn into the inlet 620 of the air blower fan 600. Air in a region other than the space under the first region 511 may become hot due to heat generated from other components of the electric range 1. Conversely, the space under the first region 511, into which external air is introduced, has a relatively low temperature. According to this embodiment, due to the presence of the rib 540, relatively cool air may be used for cooling, thereby ensuring improved cooling efficiency.

The rib 540 may include first rib 541 disposed at a right or first lateral lower end of the first region 511, a second rib 542 disposed at a front lower end of the first region 511, a third rib 543 disposed at a left or second lateral lower end of the first region 511, and a fourth rib 544 disposed at a rear lower end of the first region 511.

Although the rib 540 is shown as having a generally rectangular shape in FIG. 7, it should be understood that embodiments are not limited thereto. For example, the rib 540 may have a circular shape, or may have an n-gonal shape (n being 5 or more).

The bottom plate 510, the side plate 520, the boss portion 530, the rib 540, and the discharge portion 560, forming the second support 500, may be integrally formed, for example. The second support 500 may be manufactured by injection molding.

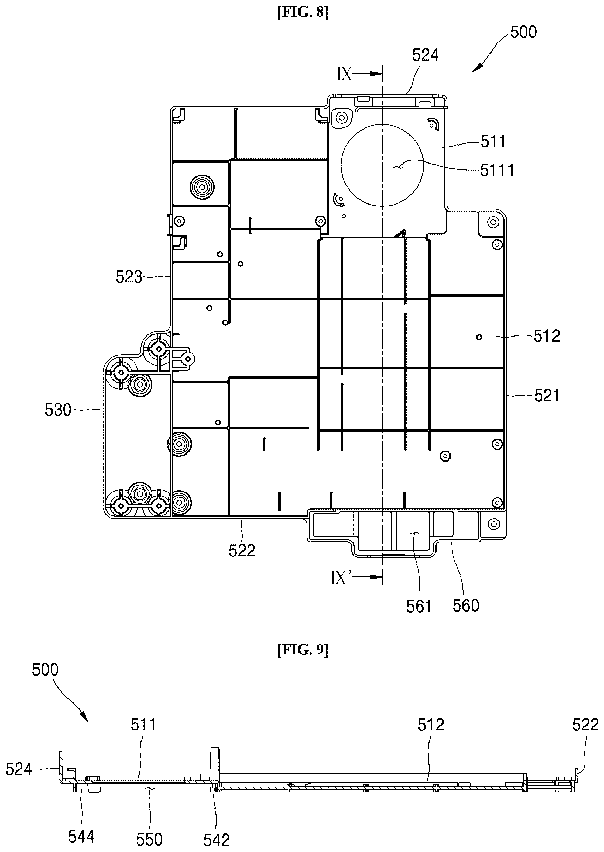

FIG. 8 is a plan view of the second support of the electric range according to an embodiment. FIG. 9 is a cross-sectional view of the second support of the electric range 1 of FIG. 8, taken along line IX-IX'.

As described above, the second support 500 may include a first region 511 in which the air blower fan 600 is mounted, and second region 512 in which the printed circuit board 800 is mounted. The first region 511 may be formed such that the inlet 620 (see FIG. 7 ) at a lower end of the air blower fan 600 is spaced apart from the upper surface of the first casing 110 of the case 100.

Referring to FIG. 9, the first region 511 may be located higher than the second region 512. That is, the lower surface of the first region 511 may be located higher than the lower surface of the second region 512. Alternatively, an upper surface of the first region 511 may be lateral higher than an upper surface of the second region 512. Accordingly, an intake space 550 may be formed under the first region 511. In addition, due to ribs 542, 544 that extend downward from the first region 511, the intake space 550 may be isolated from other spaces in the electric range 1.

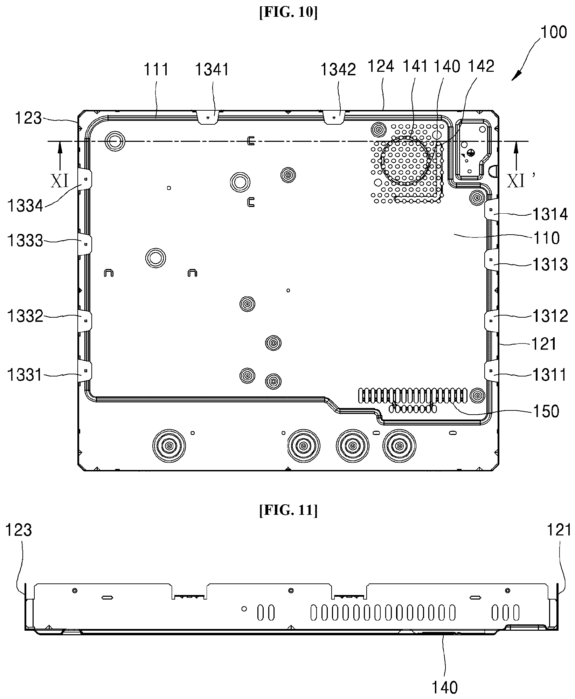

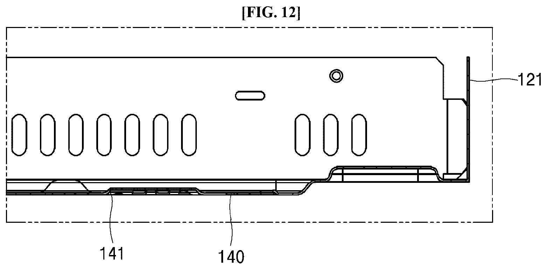

FIG. 10 is a plan view of a case of the electric range according to an embodiment. FIG. 11 is a cross-sectional view of the case of the electric range of FIG. 10, taken along line XI-XI', and FIG. 12 is an enlarged sectional view of an intake portion of the electric range of FIG. 10 according to an embodiment.

The structures and functions of the second casings 121, 122, 123, 124 and the third casings 1311, 1312, 1313, 1314, 1331, 1332, 1333, 1334, 1341, 1342 are the same as described above with reference to FIG. 3, for example.

The first casing 110 of the case 100 according to this embodiment may include an intake portion 140 and a discharge portion 150. The intake portion 140 provides a passage through which air is drawn into the inlet of the air blower fan 600 when the air blower fan 600 is in operation. The intake portion 140 may have a porous structure having multiple holes.

With the second support 500 mounted on the case 100, the intake portion 140 may correspond in location to the first region 511. In addition, the intake portion 140 may have a larger area than the inlet 620 (see FIG. 7) of the air blower fan 600. According to some embodiments, the intake portion 140 may have a same area as the first region 511. In addition, the rib 540 of the second support 500 may be disposed on the lower surface of the first region 511 to surround the intake portion 140.

The intake portion 140 may further include a first bent portion 141 and/or a second bent portion 142. The first bent portion 141 may have a circular shape; however, embodiments are not limited thereto. The second bent portion 142 may be formed near at least one edge of the intake portion 140. For example, the second bent portion 142 may be connect a region near a front edge of the intake portion 140 to a region near a right or side lateral edge of the intake portion 140, as shown in FIG. 10; however, embodiments are not limited thereto.

The first bent portion 141 and the second bent portion 142 may be formed by a forming process, for example. Each of the first bent portion 141 and the second bent portion 142 may be formed by vertically bending a portion of the intake portion 140.

A surface of the intake portion 140 inside of the bent portion 141, 142 may be on a different plane than a surface of the intake portion 140 outside of the bent portion 141, 142. For example, the surface of the intake portion 140 inside of the bent portion 141, 142 may be located higher than the surface of the intake portion 140 outside of the bent portion 141, 142. The bent portions 141, 142 of the intake portion 140 may improve rigidity of the intake portion 140.

The discharge portion 150 provides a passage through which air having passed through the air guide 700 (see FIG. 3 and FIG. 4) is discharged to the outside of the electric range 1 when the air blower fan 600 is in operation. With the second support 500 mounted on the case 100, the discharge portion 150 may correspond in location to the discharge portion 560 of the second support 500.

According to one embodiment, the first casing 110 of the case 100 includes the intake portion 140 formed at a location corresponding to the air blower fan 600, and the intake portion 140 has a porous structure having multiple holes and a larger area than the inlet of the air blower fan 600. Thus, the intake portion 140 allows a sufficient amount of air to be introduced into the air blower fan 600 therethrough while filtering out foreign substances in the air, thereby improving cooling efficiency and preventing failure of the air blower fan due to foreign substances.

In addition, the intake portion 140 has the at least one vertically bent portion 141, 142. Thus, the intake portion 140 may have a proper level of strength despite having a porous structure.

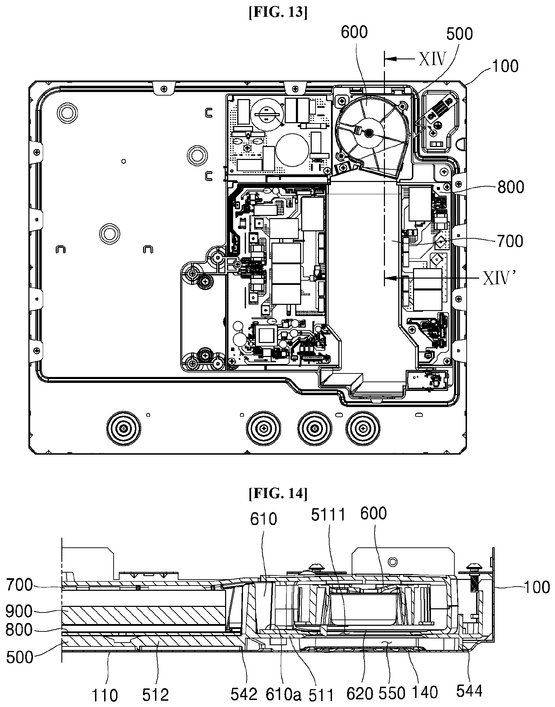

FIG. 13 is a plan view of the electric range of FIG. 4, with the upper plate, the heating modules, and the upper bracket removed therefrom. FIG. 14 is a cross-sectional view, taken along line XIV-XIV' of FIG. 13, showing a region in which the air blower fan 600 is mounted.

As described above, the electric range 1 according to this embodiment includes the second support 500 on which the printed circuit board 800 and the air blower fan 600 are mounted. That is, the second support 500 includes first region 511 in which the air blower fan 600 is mounted and second region 512 in which the printed circuit board 800 with the heat sink 900 and other electronic components mounted thereon is mounted.

The second support 500 allows the air blower fan 600 to be separated upwards from the first casing 110 of the case 100 by a predetermined distance. A distance between the lower surface of the first region 511 of the second support 500 and the upper surface of the first casing 110 may be greater than a distance between the lower surface of the second region 512 of the second support 500 and the upper surface of the first casing 110. Alternatively, the first region 511 of the second support 500 may be located higher than the second region 512 of the second support 500. In this way, the predetermined space 550 may be formed between the second region 511 of the second support 500 and the first casing 110.

The first region 511 may have the intake hole 5111. With the air blower fan 600 mounted on the second support 500, the intake hole 5111 may correspond in location to the inlet 620 of the air blower fan 600. The intake hole 5111 may have a slightly larger area than the inlet 620, or may have the same area as the inlet 620.

In addition, the first casing 110 of the case 100 may include the intake portion 140 corresponding in location to the intake hole 5111. The intake portion 140 may have a larger area than the intake hole 5111. In addition, the intake portion 140 may have a porous structure having multiple holes.

That is, according to this embodiment, the intake portion 140 having a larger area than the inlet of the air blower fan 600 may be formed on the case 100 by separating the air blower fan 600 from the case 100 using the second support 500. Accordingly, the air blower fan 600 may draw in and discharge more air due to effective increase in intake area thereof. As a result, cooling efficiency may be improved.

In addition, according to this embodiment, the second support 500 includes ribs 542, 544 that extend downward from the first region 511. The ribs 542, 544 serve to isolate the space 550 from other spaces of the electric range 1. As a result, the air blower fan 600 may draw in cold air outside the electric range 1, rather than hot air inside of the electric range 1, thereby improving cooling efficiency.

Further, according to this embodiment, the second support 500 may separate the air blower fan 600 from the case 100 such that the lower surface 610a of the outlet 610 of the air blower fan 600 is flush with or higher than the lower surface of the printed circuit board 800. The second support 500 allows the lower surface 610a of the outlet 610 of the air blower fan 600 to be on a same plane as the upper surface of the printed circuit board 800. Hereinafter, the expression "on the same plane" refers to "on substantially the same plane" considering errors in design or manufacturing processes, as well as "on exactly the same plane". The upper surface of the first region 511 may be located higher than the upper surface of the second region 512. In this way, air discharged from the air blower fan 600 may be delivered only to the upper surface of the printed circuit board 800 without being delivered to the lower surface of the printed circuit board 800. As a result, a larger amount of air may be supplied to the heat sink 900 (see FIG. 3) and other electronic components, which are attached to the upper surface of the printed circuit board 800, thereby improving cooling efficiency.

Moreover, according to this embodiment, the air blower fan 600 and the second support 500 may be mounted on the case 100 by a bolt fastened to the first casing 110 of the case 100 through the securing portion 632 and/or 633 (see FIG. 6) of the air blower fan 600 and the fan securing hole 5112 and/or 5113 (see FIG. 6 and FIG. 7) of the second support 500. In this way, even when the second support 500, for example, undergo deformation, isolation of the intake space 550 from other spaces in the electric range may be maintained, thereby preventing reduction in cooling efficiency due to deformation of the second support 500, for example.

Embodiments disclosed herein provide an electric range which may improve cooling efficiency of an air blower fan. Embodiments disclosed herein further provide an electric range which allows an air blower discharging air to an inner space of the electric range to draw in a sufficient amount of air. Embodiments disclosed herein furthermore provide an electric range which may restrain or prevent air inside of the electric range from being introduced into an air blower fan while allowing air outside of the electric range to be introduced into the air blower fan.

Embodiments disclosed herein provide an electric range which allows air discharged from an air blower fan to more efficiently cool components on a printed circuit board. Embodiments disclosed herein also provide an electric range which allows air discharged from an air blower fan to be delivered only to an upper surface of a printed circuit without being delivered to a lower surface of the printed circuit board.

Embodiments disclosed herein provide an electric range which includes a case having a proper or predetermined or sufficient level of strength while filtering out foreign substances in air to be introduced into an air blower fan. Embodiments disclosed herein additionally provide an electric range which can prevent reduction in cooling efficiency due to deformation of internal components. Embodiments disclosed herein also provide an electric range which may restrain or prevent air inside of the electric range from being introduced into an air blower fan even when internal components undergo deformation.

Advantages will become apparent from the description of embodiments in conjunction with the drawings. In addition, it will be readily understood that the advantages may be realized by features set forth in the appended claims or combinations thereof.

In accordance with embodiments disclosed herein, an electric range is provided that may include a case, and a support mounted on the case. The support may include a first region in which an air blower fan may be disposed, and a second region in which a printed circuit board may be disposed. A lower surface of the first region may be separated from the case.

In accordance with embodiments disclosed herein, an electric range is provided that may include a case, and a support mounted on the case. The support may include a first region in which an air blower fan may be disposed, and a second region in which a printed circuit board may be disposed. An average distance between the first region and the case may be greater than an average distance between the second region and the case.

In accordance with embodiments disclosed herein, an electric range is provided that may include a case and a support mounted on the case. The support may include a first region in which an air blower fan may be disposed, and a second region in which a printed circuit board may be disposed. The second region of the support may be formed with an intake through which external air is drawn in. In addition, the support may include a rib that surrounds the intake.

In accordance with embodiments disclosed herein, an electric range is provided that may include a case, and a support mounted on the case. The support may include a first region in which an air blower fan may be disposed, and a second region in which a printed circuit board may be disposed. A lower surface of an outlet of the air blower fan may be flush with or higher than a lower surface of the printed circuit board.

In accordance with embodiments disclosed herein, an electric range is provided that may include a case, and a support mounted on the case. The support may include a first region in which an air blower fan may be disposed, and a second region in which a printed circuit board may be disposed. A lower surface of an outlet of the air blower fan may be substantially flush with an upper surface of the printed circuit board.

In accordance with embodiments disclosed herein, an electric range is provided that may include a case, and a support mounted on the case. The support may include a first region in which an air blower fan may be disposed, and a second region in which a printed circuit board may be disposed. The case may include an intake portion formed in a region corresponding to the second region of the support.

The intake portion of the case may have multiple holes allowing passage of air therethrough. Further, the intake portion of the case may have a larger area than an inlet of the air blower fan.

The intake portion of the case may have a bent portion. An inner surface of the intake portion of the case surrounded by the bent portion may be on a different plane than a surface of the intake portion outside the bent portion.

In accordance with embodiments disclosed herein, an electric range is provided that may include a case, and a support mounted on the case. The support may include a first region in which an air blower fan may be disposed, and a second region in which a printed circuit board may be disposed. The air blower fan may be secured to the support by a coupling member fastened to the case through the air blower fan and the support.

In accordance with embodiments disclosed herein, an electric range is provided that may include a case defining an external appearance of the electric range; a heater that heats a heating object; an upper bracket disposed under the heater to support the heater; and a support disposed under the upper bracket. The support may include a first region on which an air blower fan may be mounted, and a second region on which a printed circuit board may be mounted. A lower surface of the first region may be separated upward from the case.

The electric range may further include an upper plate disposed over the case and having an upper surface on which the heating object is disposed, and the heater may be disposed under the upper plate.

The air blower fan may include an inlet disposed at a lower portion thereof and allowing air to be drawn into the air blower fan therethrough. The support may further include an intake hole formed in the first region at a location corresponding to the inlet of the air blower fan, and the case may include an intake portion formed at a location corresponding to the intake hole and providing a passage through which air is drawn into the air blower fan. The intake portion and the intake hole may be separated vertically from each other.

The intake portion may have a larger area than the inlet of the air blower fan. The support may further include a rib that extends downward from the first region and surrounds the intake hole. The intake portion may have a porous structure having multiple holes, and may include a vertically bent portion therein.

An upper surface of the first region may be placed higher than an upper surface of the second region.

The air blower fan may further include an outlet through which air is discharged from the air blower fan. The outlet may have a lower surface placed higher than a lower surface of the printed circuit board.

The air blower fan may include a securing portion through which a bolt passes. The support may include a fan securing hole through which the bolt passes, and the bolt may be fastened to the case through the securing portion and the fan securing hole.

In accordance with embodiments disclosed herein, an electric range is provided that may include a case defining an external appearance of the electric range; an upper plate disposed over the case and having an upper surface on which a heating object is disposed; a heater that is disposed under the upper plate and heats the heating object; an upper bracket disposed under the heater to support the heater and coupled to the case; and a support disposed under the upper bracket and mounted on the case. The support may include a first region on which an air blower fan may be mounted, and a second region on which a printed circuit board may be mounted. An average vertical distance between a lower surface of the first region and the case may be greater than an average vertical distance between a lower surface of the second region and the case.

The electric range according to embodiments disclosed herein may improve cooling efficiency of an air blower fan. The electric range according to embodiments disclosed herein allows an air blower discharging air to an inner space of the electric range to draw in a sufficient amount of air. The electric range according to embodiments disclosed herein may restrain or prevent air inside of the electric range from being introduced into an air blower fan while allowing air outside of the electric range to be introduced into the air blower fan.

The electric range according to embodiments disclosed herein allows air discharged from an air blower fan to more efficiently cool components on a printed circuit board. The electric range according to embodiments disclosed herein allows air discharged from an air blower fan to be delivered only to an upper surface of a printed circuit without being delivered to a lower surface of the printed circuit board.

The electric range according to embodiments disclosed herein may include a case having a proper or predetermined or sufficient level of strength while filtering out foreign substances in air to be introduced into an air blower fan. The electric range according to embodiments disclosed herein may prevent a reduction in cooling efficiency due to deformation of internal components. The electric range according to embodiments disclosed herein may restrain or prevent air inside of the electric range from being introduced into an air blower fan even when internal components undergo deformation.

Although embodiments have been described herein, it should be understood by those skilled in the art that these embodiments are given by way of example only, and that various modifications, variations, and alterations can be made without departing from the scope. In addition, although advantageous effects provided by a certain configuration are not clearly described in description of the exemplary embodiments, it should be noted that expectable effects of the corresponding configuration should be acknowledged.

It will be understood that when an element or layer is referred to as being "on" another element or layer, the element or layer can be directly on another element or layer or intervening elements or layers. In contrast, when an element is referred to as being "directly on" another element or layer, there are no intervening elements or layers present. As used herein, the term "and/or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section could be termed a second element, component, region, layer or section without departing from the teachings of the present invention.

Spatially relative terms, such as "lower" and "upper", for example, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" relative to other elements or features would then be oriented "upper" relative to the other elements or features. Thus, the exemplary term "lower" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments are described herein with reference to cross-section illustrations that are schematic illustrations of idealized embodiments (and intermediate structures). As such, variations from the shapes of the illustrations as a result, for example, of manufacturing techniques and/or tolerances, are to be expected. Thus, embodiments should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. An electric range, comprising:
a case (100) that defines an external appearance of the electric range;
at least one heater (310, 320, 330) for heating an item;
an upper bracket (210, 220) that is disposed under the at least one heater (310, 320, 330) to support the at least one heater (310, 320, 330); and
the electric range further comprising:
a support (500) disposed under the upper bracket (210, 220), wherein the support (500) comprises a first region (511) on which an air blower fan (600) is mounted, and a second region (512) on which a printed circuit board (800) is mounted, and wherein a lower surface of the first region (511) is separated upward from the case (100), whereby the first region (511) is located higher than the second region (512),
wherein the air blower fan (600) comprises an inlet (620) disposed at a lower portion thereof,
wherein the support (500) further comprises an intake hole (5111) formed in the first region (511) at a location corresponding to the inlet (620) of the air blower fan (600), and
wherein the case (100) comprises an intake portion (140) that is formed at a location corresponding to the intake hole (5111) and provides a passage through which air is drawn into the air blower fan (600),
wherein the electric range further comprises an intake space (550) formed under the first region (511).

2. The electric range according to claim 1, further comprising:
an upper plate (20) disposed over the case (100) and having an upper surface on which the item is placeable, and
wherein the at least one heater (310, 320, 330) is disposed under the upper plate (20).

3. The electric range according to claim 1, wherein:
the intake portion (140) and the intake hole (5111) are separated vertically from each other.

4. The electric range according to claim 1 or 3, wherein the intake portion (140) has an area larger than an area of the inlet (620) of the air blower fan (600).

5. The electric range according to nay one of claims 2 to 4, wherein the support (500) further comprises at least one rib (540) that extends downward from the first region (511) and surrounds the intake hole (5111).

6. The electric range according to any one of claims 2 to 5, wherein the intake portion (140) has a porous structure including a plurality of holes and comprises a vertically bent portion (141, 142) therein.

7. The electric range according to any one of claims 1 to 6, wherein an upper surface of the first region (511) is located higher than an upper surface of the second region (512).

8. The electric range according to claim 7, wherein the air blower fan (600) comprises an outlet (610) through which air is discharged from the air blower fan (600), the outlet (610) having a lower surface located higher than a lower surface of the printed circuit board (800).

9. The electric range according to any one of claims 1 to 8, wherein:
the air blower fan (600) comprises a securing portion (632, 633) through which a bolt passes;
the support (500) comprises a fan securing hole (5112, 5113) through which the bolt passes; and
the bolt is fastened to the case (100) through the securing portion (632, 633) and the fan securing hole (5112, 5113).

10. The electric range according to any one of claims 1 to 9, wherein an average vertical distance between a lower surface of the first region (511) and the case (100) is greater than an average vertical distance between a lower surface of the second region (512) and the case (100).

## Patentansprüche

1. Elektroherd, umfassend:
ein Gehäuse (100), das ein äußeres Erscheinungsbild des Elektroherds definiert;
zumindest ein Heizelement (310, 320, 330) zum Erwärmen eines Gegenstands;
eine obere Halterung (210, 220), die unter dem zumindest einen Heizelement (310, 320, 330) angeordnet ist, um das zumindest eine Heizelement (310, 320, 330) zu tragen; und
wobei der Elektroherd ferner umfasst:
einen Träger (500), der unter der oberen Halterung (210, 220) angeordnet ist, wobei der Träger (500) einen ersten Bereich (511), auf dem ein Gebläselüfter (600) montiert ist, und einen zweiten Bereich (512), auf dem eine Leiterplatte (800) montiert ist, umfasst, und wobei eine Unterseite des ersten Bereichs (511) nach oben von dem Gehäuse (100) beabstandet ist, wodurch der erste Bereich (511) höher als der zweite Bereich (512) angeordnet ist,
wobei der Gebläselüfter (600) einen an einem unteren Abschnitt desselben angeordneten Einlass (620) umfasst,
wobei der Träger (500) ferner eine Ansaugöffnung (5111) umfasst, die in dem ersten Bereich (511) an einer dem Einlass (620) des Gebläselüfters (600) entsprechenden Stelle ausgebildet ist, und
wobei das Gehäuse (100) einen Ansaugabschnitt (140) umfasst, der an einer der Ansaugöffnung (5111) entsprechenden Stelle ausgebildet ist und einen Durchgang bereitstellt, durch den Luft in den Gebläselüfter (600) eingesaugt wird,
wobei der Elektroherd ferner einen unter dem ersten Bereich (511) ausgebildeten Ansaugraum (550) umfasst.

2. Elektroherd nach Anspruch 1, ferner umfassend:
eine obere Platte (20), die über dem Gehäuse (100) angeordnet ist und eine Oberseite aufweist, auf der der Gegenstand platzierbar ist, und
wobei das zumindest eine Heizelement (310, 320, 330) unter der oberen Platte (20) angeordnet ist.

3. Elektroherd nach Anspruch 1, wobei:
der Ansaugabschnitt (140) und die Ansaugöffnung (5111) vertikal voneinander beabstandet sind.

4. Elektroherd nach Anspruch 1 oder 3, wobei der Ansaugabschnitt (140) eine Fläche aufweist, die größer als eine Fläche des Einlasses (620) des Gebläselüfters (600) ist.

5. Elektroherd nach einem der Ansprüche 2 bis 4, wobei der Träger (500) ferner zumindest eine Rippe (540) umfasst, die sich von dem ersten Bereich (511) nach unten erstreckt und die Ansaugöffnung (5111) umgibt.

6. Elektroherd nach einem der Ansprüche 2 bis 5, wobei der Ansaugabschnitt (140) eine poröse Struktur aufweist, die eine Vielzahl von Löchern beinhaltet, und darin einen vertikal gebogenen Abschnitt (141, 142) umfasst.

7. Elektroherd nach einem der Ansprüche 1 bis 6, wobei eine Oberseite des ersten Bereichs (511) höher als eine Oberseite des zweiten Bereichs (512) angeordnet ist.

8. Elektroherd nach Anspruch 7, wobei der Gebläselüfter (600) einen Auslass (610) umfasst, durch den Luft aus dem Gebläselüfter (600) ausgestoßen wird, wobei der Auslass (610) eine Unterseite aufweist, die höher als eine Unterseite der Leiterplatte (800) angeordnet ist.

9. Elektroherd nach einem der Ansprüche 1 bis 8, wobei:
der Gebläselüfter (600) einen Befestigungsabschnitt (632, 633) umfasst, durch den ein Bolzen hindurchtritt;
der Träger (500) ein Lüfterbefestigungsloch (5112, 5113) umfasst, durch das der Bolzen hindurchtritt; und
der Bolzen durch den Befestigungsabschnitt (632, 633) und das Lüfterbefestigungsloch (5112, 5113) hindurch an dem Gehäuse (100) befestigt ist.

10. Elektroherd nach einem der Ansprüche 1 bis 9, wobei ein durchschnittlicher vertikaler Abstand zwischen einer Unterseite des ersten Bereichs (511) und dem Gehäuse (100) größer als ein durchschnittlicher vertikaler Abstand zwischen einer Unterseite des zweiten Bereichs (512) und dem Gehäuse (100) ist.

## Revendications

1. Cuisinière électrique, comprenant :
un boîtier (100) qui définit l'aspect extérieur de la cuisinière électrique ;
au moins un élément chauffant (310, 320, 330) destiné à chauffer un objet ;
un étrier supérieur (210, 220) qui est disposé sous ledit au moins un élément chauffant (310, 320, 330) afin de supporter ledit au moins un élément chauffant (310, 320, 330) ; et
la cuisinière électrique comprenant en outre :
un support (500) disposé sous l'étrier supérieur (210, 220), dans laquelle le support (500) comprend une première région (511) sur laquelle est monté un ventilateur de soufflage (600), et une seconde région (512) sur laquelle est montée une carte de circuit imprimé (800), et dans laquelle une surface inférieure de la première région (511) est espacée vers le haut du boîtier (100), de sorte que la première région (511) est située plus haut que la seconde région (512),
dans laquelle le ventilateur de soufflage (600) comprend une entrée (620) disposée au niveau d'une partie inférieure de celui-ci,
dans laquelle le support (500) comprend en outre un orifice d'admission (5111) formé dans la première région (511) à un emplacement correspondant à l'entrée (620) du ventilateur de soufflage (600), et
dans laquelle le boîtier (100) comprend une partie d'admission (140) qui est formée à un emplacement correspondant à l'orifice d'admission (5111) et qui fournit un passage par lequel de l'air est aspiré dans le ventilateur de soufflage (600),
dans laquelle la cuisinière électrique comprend en outre un espace d'admission (550) formé sous la première région (511).

2. Cuisinière électrique selon la revendication 1, comprenant en outre :
une plaque supérieure (20) disposée au-dessus du boîtier (100) et présentant une surface supérieure sur laquelle l'objet peut être placé, et
dans laquelle ledit au moins un élément chauffant (310, 320, 330) est disposé sous la plaque supérieure (20).

3. Cuisinière électrique selon la revendication 1, dans laquelle :
la partie d'admission (140) et l'orifice d'admission (5111) sont espacés verticalement l'un de l'autre.

4. Cuisinière électrique selon la revendication 1 ou 3, dans laquelle la partie d'admission (140) présente une superficie supérieure à une superficie de l'entrée (620) du ventilateur de soufflage (600).

5. Cuisinière électrique selon l'une quelconque des revendications 2 à 4, dans laquelle le support (500) comprend en outre au moins une nervure (540) qui s'étend vers le bas depuis la première région (511) et entoure l'orifice d'admission (5111).

6. Cuisinière électrique selon l'une quelconque des revendications 2 à 5, dans laquelle la partie d'admission (140) présente une structure poreuse comprenant une pluralité de trous et comprend en son sein une partie pliée verticalement (141, 142).

7. Cuisinière électrique selon l'une quelconque des revendications 1 à 6, dans laquelle une surface supérieure de la première région (511) est située plus haut qu'une surface supérieure de la seconde région (512).

8. Cuisinière électrique selon la revendication 7, dans laquelle le ventilateur de soufflage (600) comprend une sortie (610) par laquelle de l'air est évacué du ventilateur de soufflage (600), la sortie (610) présentant une surface inférieure située plus haut qu'une surface inférieure de la carte de circuit imprimé (800).

9. Cuisinière électrique selon l'une quelconque des revendications 1 à 8, dans laquelle :
le ventilateur de soufflage (600) comprend une partie de fixation (632, 633) à travers laquelle passe un boulon ;
le support (500) comprend un trou de fixation du ventilateur (5112, 5113) à travers lequel passe le boulon ; et
le boulon est fixé au boîtier (100) à travers la partie de fixation (632, 633) et le trou de fixation du ventilateur (5112, 5113).

10. Cuisinière électrique selon l'une quelconque des revendications 1 à 9, dans laquelle une distance verticale moyenne entre une surface inférieure de la première région (511) et le boîtier (100) est supérieure à une distance verticale moyenne entre une surface inférieure de la seconde région (512) et le boîtier (100).
